# EUROPEAN PATENT APPLICATION

(11) **EP 4 804 651 A1**
(43) Date of publication of application: **09.09.2026**
(21) Application number: 25162386.4
(22) Date of filing: 07.03.2025
(51) Int. Cl.: H04W 52/36, H03G 3/00, H04W 52/52

(54) **OPTIMISING MAXIMUM POWER REDUCTION IN A WIRELESS COMMUNICATION NETWORK**

(71) Applicant: Vodafone Group Services Limited, Newbury RG14 2FN (GB)
(72) Inventor: BOUKLEY HASAN, Wael, London, W2 6BY (GB)
(74) Representative: Boult Wade Tennant LLP

(57) **Abstract**

There is described herein a method of operating user equipment in a telecommunications network in which a power amplifier in the user equipment operates in accordance with a maximum power reduction to limit transmit power of the user equipment. The method comprises operating the power amplifier according to the maximum power reduction while transmitting signals from the user equipment and measuring a metric characterising performance of the power amplifier. The metric is compared against a threshold that indicates a pre-defined level of performance of the power amplifier. When the comparison of the metric against the threshold indicates that the power amplifier is exceeding the pre-defined level of performance, the maximum power reduction is revised to a lower value.

## Description

### FIELD OF INVENTION

The disclosure relates generally to wireless communications in a network and more specifically, methods for optimising maximum power reduction in a wireless communication network.

### BACKGROUND OF THE INVENTION

In wireless communication networks in which devices communicate with a network (for example, 3GPP cellular networks), efficient communications and overall network performance can depend on power control within the network. For example, the transmission power of the device may directly impact uplink (end device to network) coverage and interference management.

For user equipment, UEs, in a cellular network, 3GPP standards (for example, LTE, 5G NR, and so on) define mechanisms to regulate UE transmission power and the spectral emissions of the UE. For example, power is limited to 23 dBm for power class three (PC3) in 3GPP. Limiting power attempts to maintain sufficiently strong signal strength for reliable connectivity, whilst also minimising excessive power that could cause interference, for example cross-channel leakage. Precise device power management can help mitigate uplink interference, preventing high-power devices from degrading the signal quality of other users or, in cellular networks, neighbouring cells.

Maximum Power Reduction (MPR) is a further mechanism in 3GPP standards that limits the maximum transmit power of UE to maintain spectral compliance, i.e. to keep leakage of emissions into adjacent channels within acceptable limits.

Currently, maximum power reduction is statically defined in 3GPP specifications (e.g., TS 38.101 for NR, TS 36.101 for LTE), and is set to prevent spectral emissions from exceeding regulatory thresholds. The same maximum power reduction values apply across all UEs regardless of the power amplifiers they employ. For UEs having power amplifiers with good efficiency and linearity, the maximum power reduction value is overly conservative which leads to excessive power backoff. Also, setting over-restrictive maximum power reduction unnecessarily reduces uplink coverage, particularly for cell-edge users, limiting overall network capacity and performance.

### SUMMARY

From a first aspect, the present invention resides in a method of operating user equipment in a telecommunications network in which a power amplifier in the user equipment operates in accordance with a maximum power reduction to limit transmit power of the user equipment. The method comprises operating the power amplifier according to the maximum power reduction while transmitting signals from the user equipment and measuring a metric characterising performance of the power amplifier. The metric is compared against a threshold that indicates a pre-defined level of performance. When the comparison of the metric against the threshold indicates that the power amplifier is exceeding the pre-defined level of performance, the maximum power reduction is revised to a lower value. Then, the power amplifier is operated according to the decreased maximum power reduction while transmitting signals from the user equipment.

In this way, a power amplifier working well is not penalised by an excessive maximum power reduction that is put in place to account for poorly performing operational amplifiers.

The steps of measuring the metric, comparing the metric against the threshold and revising the maximum power reduction may be performed periodically.

The method may further comprise comparing the metric against a further threshold that indicates a further pre-defined level of performance. When the comparison of the metric against the further threshold indicates that the power amplifier is failing to meet the further pre-defined level of performance, the maximum power reduction is revised to a higher value. The power amplifier is then operated according to the increased maximum power reduction while transmitting signals from the user equipment.

In this way, a dynamic maximum power reduction is realised that adjusts to the current performance of the power amplifier. This can be contrasted to the conventional approach of enforcing a static maximum power reduction that is set to limit power according to worst cases to ensure spectral requirements are met and out-of-band limits are not exceeded.

The method may be implemented in different ways. Different metrics may be used. The metric should characterise the performance of the power amplifier, in particular the performance as reflected in the spectral compliance of the user equipment. Thus, the metric may reflect the performance of the power amplifier in minimising leakage into adjacent channels.

As a first example, the metric may characterise the efficiency of the power amplifier. The efficiency may be quantified as how efficiently input power is converted to transmitted power. A further example for the metric is that the metric may characterise the error vector magnitude in signals transmitted by the user equipment. This magnitude may be a measure of signal distortion due to nonlinearity in the power amplifier. Also, the metric may characterise adjacent channel leakage ratio, such as the ratio of signal power in the user equipment channel to the signal in the adjacent channels. For example, the metric may utilize adjacent channel leakage ratio (ACLR), which compares the power in the adjacent channel to the power in the main channel.

The metrics describe in the preceding paragraph may be used as alternatives, or two or all three of the metrics may be used in combination when determining whether to revise the maximum power reduction.

Optionally, the user equipment may perform the steps of measuring the metric characterising performance of the power amplifier, comparing the metric against the threshold that indicates the pre-defined level of performance and/or against the threshold that indicates the pre-defined level of performance and revising the maximum power reduction to a lower and/or higher value when the comparison of the metric against the threshold indicates that the power amplifier is exceeding the pre-defined level of performance and/or not meeting the further pre-defined level of performance respectively. In this case, the user equipment may transmit a signal to a base station of the telecommunications network to report the revised maximum power reduction.

Alternatively, a base station of the telecommunications network may perform the steps of measuring the metric characterising performance of the power amplifier, comparing the metric against the threshold that indicates the pre-defined level of performance and/or against the threshold that indicates the pre-defined level of performance and revising the maximum power reduction to a lower and/or higher value when the comparison of the metric against the threshold indicates that the power amplifier is exceeding the pre-defined level of performance and/or not meeting the further pre-defined level of performance respectively. The base station may then transmit a signal to the user equipment network to notify the user equipment of the revised (decreased or increased) maximum power reduction to be used when transmitting signals.

The present invention also extends to one or more computer programs comprising instructions that, when executed by one or more computer processors, cause the one or more computer processors to implement any of the methods described above, and to one or more computer-readable media comprising the one or more computer programs. A single computer program may be used, or two or more computer programs may be used that work together via separate devices, for example a computer program running on user equipment and a computer program running on a base station or other piece of network infrastructure.

The method according to the first aspect of the present invention may be implemented by the user equipment alone, and so the present invention also extends to user equipment configured to operate in a telecommunications network, the user equipment comprising one or more computer processors and computer memory having stored therein a computer program comprising instructions that, when executed by the one or more computer processors, cause the one or more computer processors to implement any of the methods described above. The method according to the first aspect of the present invention may be implemented by the user equipment in combination with a base station, and so the present invention also extends to a telecommunications network comprising a base station and user equipment connected to the base station, wherein the telecommunications network comprises one or more computer processors and one or more computer memories having stored therein one or more computer programs comprising instructions that, when executed by one or more computer processors, cause the one or more computer processors to implement any of the methods described above. For example, the computer memories may be provided by the user equipment and the base station, and the computer processors may also be provided by the user equipment and the base station.

### LIST OF FIGURES

In order that the invention can be more readily understood, reference will now be made by way of example only, to the accompanying drawings in which:
Figure 1 is a schematic representation of a method of operating user equipment in a telecommunications network according to a first embodiment of the present invention; and
Figure 2 is a schematic representation of a method of operating user equipment in a telecommunications network according to a second embodiment of the present invention.

### DETAILED DESCRIPTION

The present invention relates to the operation of user equipment (UE) in a telecommunications network, such as a 3GPP cellular network. In particular, the present invention relates to operating UE according to a variable maximum power reduction (MPR), rather than operating according to a fixed maximum power reduction.

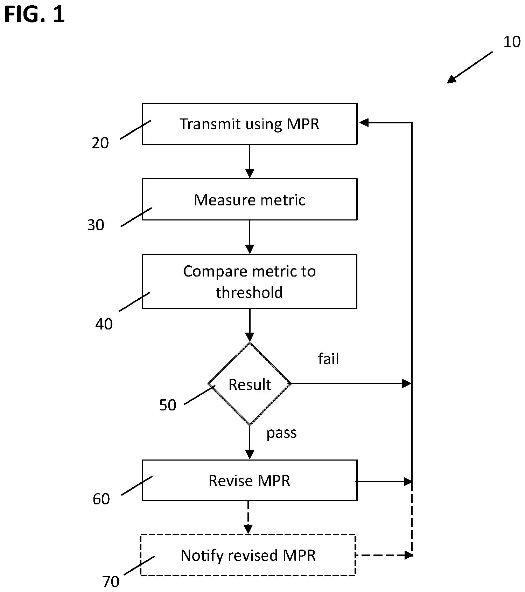

Figure 1 shows an embodiment of such a method 10. At step 20, the UE transmits messages. When transmitting messages, the power amplifier of the UE will reduce the power of the transmitted signal by a predefined maximum power reduction which usually limits the transmitted power. As described above, the predefined maximum power reduction is set conservatively so that UEs with poorly performing power amplifiers still meet regulatory requirements with regard to leakage of signal power into adjacent channels. Consequently, the signal power of the UE in its channel is often significantly below the regulated limited (23 dBm in this instance).

At step 30, a metric characterising performance of the power amplifier is measured. At step 40, the measured metric is compared against a threshold that indicates a pre-defined level of performance of the power amplifier. This comparison is effectively a test to determine whether the power amplifier is exceeding the corresponding pre-defined level of performance, as indicated at step 50 of Figure 1.

If this test 50 is failed (i.e. the power amplifier is not exceeding the pre-defined level of performance), the maximum power reduction remains unchanged and the method 10 returns to step 20 where the UE continues to transmit messages using the predefined maximum power reduction. Subsequent steps 30, 40 and 50 see further evaluation of how the power amplifier is performing.

Conversely, if test 50 is passed (i.e. the power amplifier is exceeding the pre-defined level of performance), the maximum power reduction is revised to a lower value. This lesser reduction leads to an increase in signal power. Figure 1 shows an optional step, step 70, that sees a notification of the revised maximum power reduction transmitted. To where and from where this signal is transmitted depends on how the steps of method 10 are implemented. If all steps are implemented by the UE, then optional step 70 may see the UE perform step 70 by transmitting the revised maximum power reduction to the base station of the telecommunication network to which the UE is currently connected. Alternatively, the base station of the telecommunication network may evaluate how the power amplifier is performing by implementing steps 30, 40, 50 and 60. In this case, the base station must implement step 70 by sending a notification of the revised maximum power reduction to the UE so that the UE can begin transmitting signals using the revised maximum power reduction. In either event, once the maximum power reduction has been revised at step 60, the method 10 returns to step 20, where the UE transmits signals, this time using the revised maximum power reduction.

The method 10 then loops through further iterations of steps 30 to 50 where the performance of the power amplifier is tested once more.

For example, if the decrease in the maximum power reduction still leaves the power amplifier operating above the pre-defined level of performance, the maximum power reduction is decreased still further. This continues until the power amplifier's performance is found not to exceed the pre-defined level of performance. For a very well performing power amplifier, the maximum power reduction may be decreased to zero in which case the transmitted power will rise to the maximum allowed (e.g. 23 dBm). This is acceptable as the UE is still operating within the pre-defined level of performance such that leakage into adjacent channels remains within allowed limits.

There are different options available in the choice of a suitable metric that characterises the performance of the power amplifier and hence spectral compliance such as the leakage into adjacent channels.

For example, measuring the metric at step 30 may comprise measuring the power amplifier efficiency. This may be measured in any conventional way. Alternatively, measuring the metric at step 30 may comprise measuring the error vector magnitude. This may be measured in any conventional way. A further alternative sees the adjacent channel leakage ratio measured at step 30. This may be measured in any conventional way. This may be measured at the user equipment, for example where the user equipment is equipped with an advanced power amplifier with capabilities to estimate the adjacent channel leakage ratio or using artificial intelligence/machine learning to estimate ACLR and EVM. The adjacent channel leakage ratio can be measured by the base station to which the user equipment is connected. The base station may measure the signal strength received from the user equipment both on its allocated channel and on the adjacent channel. The base station may send the adjacent channel leakage ratio measured in this way to the user equipment.

A person skilled in the art will appreciate that the above embodiments may be varied in many different respects without departing from the scope of the present invention that is defined by the appended claims.

For instance, four examples of metrics that characterises the performance of the power amplifier and hence spectral compliance such as the leakage into adjacent channels were given above: the power amplifier efficiency, the error vector magnitude and the adjacent channel leakage ratio. Alternative arrangements may see two or three of these metrics used, and combinations with other metrics are possible.

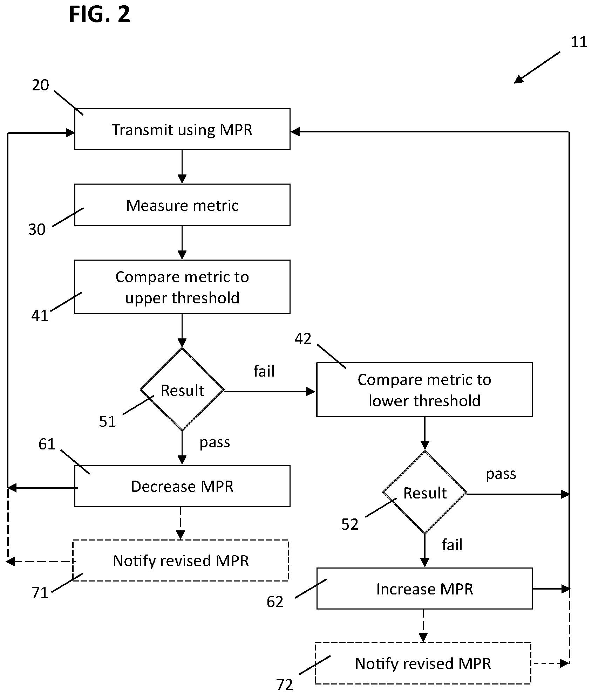

Also, the method 10 of Figure 1 monitors for situations where the power amplifier is exceeding the pre-defined level of performance and decreases the maximum power reduction when this is found to be the case. Certain factors may arise that see the performance of the power amplifier decrease and so it may no longer be appropriate to operate at a lower maximum power reduction. Figure 2 shows a further method 11 that provides for increasing the maximum power reduction.

As before, step 20 sees the UE transmits messages and step 30 sees a metric characterising performance of the power amplifier measured. Step 41 is similar to step 40, but now the measured metric is compared against an upper threshold that indicates a pre-defined higher level of performance of the power amplifier. This comparison is effectively a test to determine whether the power amplifier is exceeding the corresponding pre-defined higher level of performance, as indicated at step 51 of Figure 2.

If test 51 is passed (i.e. the power amplifier is exceeding the pre-defined higher level of performance), the maximum power reduction is revised to a lower value at step 61. This lesser reduction leads to an increase in signal power. Figure 2 shows optional step 71 that sees a notification of the revised maximum power reduction transmitted, in the same way as for step 70 previously described.

If this test 51 is failed (i.e. the power amplifier is not exceeding the upper pre-defined level of performance), method 11 moves to step 42 where the measured metric is now compared against a lower threshold that indicates a pre-defined lower level of performance of the power amplifier. This comparison is effectively a test to determine whether the power amplifier has fallen below the corresponding pre-defined lower level of performance, as indicated at step 52 of Figure 2.

If this test 52 is passed (i.e. the power amplifier is not exceeding the upper pre-defined level of performance and is not below the lower pre-defined level of performance), the maximum power reduction remains unchanged and the method 11 returns to step 20 where the UE continues to transmit messages using the predefined maximum power reduction. Subsequent steps 30, 41, 51, 42 and 52 see further evaluation of how the power amplifier is performing. However, if test 52 is failed (i.e. the power amplifier is performing below the lower pre-defined level of performance), method 11 moves to step 62 where the maximum power reduction is revised to a higher value at step 62. This greater reduction leads to a decrease in signal power so as to reduce leakage into adjacent channels. Figure 2 shows optional step 72 that sees a notification of the revised maximum power reduction transmitted, in the same way as for steps 70 and 71 previously described.

Once the maximum power reduction has been adjusted at either step 61 or 62, the method 11 then loops through further iterations of steps 30, 41, 51, 42 and 52 where the performance of the power amplifier is tested once more.

The values of the upper and lower threshold may be varied as desired and may even be set to the same value. Using different values provides a deadband and so prevents constant adjustment of the maximum power reduction value and oscillation of the maximum power reduction about a value that provides acceptable performance under current conditions.

## Claims

1. A method of operating user equipment in a telecommunications network in which a power amplifier in the user equipment operates in accordance with a maximum power reduction to limit transmit power of the user equipment, the method comprising:
operating the power amplifier according to the maximum power reduction while transmitting signals from the user equipment;
measuring a metric characterising performance of the power amplifier;
comparing the metric against a threshold that indicates a pre-defined level of performance of the power amplifier;
when the comparison of the metric against the threshold indicates that the power amplifier is exceeding the pre-defined level of performance, revising the maximum power reduction to a lower value; and
operating the power amplifier according to the revised maximum power reduction while transmitting signals from the user equipment.

2. The method of claim 1, further comprising:
comparing the metric against a further threshold that indicates a further pre-defined level of performance of the power amplifier;
when the comparison of the metric against the further threshold indicates that the power amplifier is failing to meet the further pre-defined level of performance, revising the maximum power reduction to a higher value; and
operating the power amplifier according to the revised maximum power reduction while transmitting signals from the user equipment.

3. The method of claim 1 or 2, wherein the metric characterises the efficiency of the power amplifier.

4. The method of claim 1 or 2, wherein the metric characterises the error vector magnitude in signals transmitted by the user equipment.

5. The method of claim 1 or 2, wherein the metric characterises adjacent channel leakage ratio.

6. The method of any preceding claim, wherein the user equipment measures the metric characterising performance of the power amplifier, compares the metric against the threshold that indicates the pre-defined level of performance and/or against the threshold that indicates the pre-defined level of performance and revises the maximum power reduction to a lower and/or higher value when the comparison of the metric against the threshold indicates that the power amplifier is exceeding the pre-defined level of performance and/or not meeting the further pre-defined level of performance respectively.

7. The method of claim 6, further comprising the user equipment transmitting a signal to a base station of the telecommunications network to report the revised maximum power reduction.

8. The method of any of claims 1 to 5, wherein a base station of the telecommunications network measures the metric characterising performance of the power amplifier, compares the metric against the threshold that indicates the pre-defined level of performance and/or against the threshold that indicates the pre-defined level of performance and revises the maximum power reduction to a lower and/or higher value when the comparison of the metric against the threshold indicates that the power amplifier is exceeding the pre-defined level of performance and/or not meeting the further pre-defined level of performance respectively.

9. The method of claim 8, further comprising the base station transmitting a signal to the user equipment network to notify the user equipment of the revised maximum power reduction to be used when transmitting signals.

10. One or more computer programs comprising instructions that, when executed by one or more computer processors, cause the one or more computer processors to implement the method of any previous claim.

11. One or more computer-readable media comprising the one or more computer programs according to claim 10.

12. User equipment configured to operate in a telecommunications network, the user equipment comprising one or more computer processors and computer memory having stored therein the one or more computer programs according to claim 10.

13. A telecommunications network comprising a base station and user equipment connected to the base station, wherein the telecommunications network comprises one or more computer processors and one or more computer memories having stored therein the one or more computer programs according to claim 10.
